# FASCICULE DE BREVET EUROPEEN

(11) **EP 1 554 916 B1**
(45) Date de publication et mention de la délivrance du brevet: **16.04.2008**
(21) Numéro de dépôt: 03809764.8
(22) Date de dépôt: 10.10.2003
(51) Int. Cl.: H05K 7/14

(54) **DISPOSITIF DE FIXATION PAR VERROUILLAGE D UN APPAREIL DESTIN E A ETRE MONTE DANS UN RACK**
EINRICHTUNG ZUR VERRIEGELTEN ANBRINGUNG EINER FÜR RACKMONTAGE AUSGELEGTEN VORRICHTUNG
DEVICE FOR LOCK-FIXING AN APPARATUS DESIGNED TO BE MOUNTED IN A RACK

(30) Priorité: 25.10.2002 FR 0213413
(43) Date de publication de la demande: 20.07.2005
(73) Titulaire: Thales, 92200 Neuilly Sur Seine (FR); AIRBUS France, 31060 Toulouse (FR)
(72) Inventeur: LARET, Daniel Thales Intellectual Property, F-94117 Arcueil Cedex (FR); SALANQUEDA, Laurent Thales Intellectual Property, F-94117 Arcueil Cedex (FR)
(74) Mandataire: Esselin, Sophie
(86) Numéro de dépôt international: PCT/FR2003/003000
(87) Numéro de publication internationale: WO 2004/040951

(56) Documents cités:
- FR-A- 2 625 829
- FR-A- 2 787 282
- GB-A- 2 015 828

## Description

La présente invention concerne un dispositif de fixation par verrouillage d'un appareil monté dans un rack, et concerne notamment la fixation d'appareils radioélectriques ou électroniques, à l'aide d'une fixation du type "à verrouillage". Elle s'applique de manière particulièrement avantageuse aux appareils dits "embarqués", montés par exemple dans des avions, des chars etc...

Les racks sont des châssis dans lesquels des appareils peuvent être placés soit seuls, soit côte à côte et/ou superposés pendant leur fonctionnement. L'arrière de chacun de ces appareils comporte généralement un ou plusieurs connecteurs, électriques ou autres, auxquels correspondent des connecteurs disposés dans le fond d'un espace attribué à chaque appareil dans le rack. Ces connecteurs montés sur le rack sont reliés, à l'arrière de ce dernier, entre eux ou vers d'autres équipements ; l'enfoncement d'un appareil dans l'espace qui lui est attribué a pour effet d'établir les connexions nécessaires à son fonctionnement, par exemple des connexions électriques.

L'intérêt de placer des appareils dans des racks réside notamment dans la rapidité et la facilité de leur installation. Il est donc avantageux de maintenir fixés ces appareils dans leur position de fonctionnement dans les racks, à l'aide de systèmes dits "à verrouillage" dont la manoeuvre est simple et rapide, aussi bien pour installer ces appareils dans le rack que pour les extraire de ce rack. La position de fonctionnement constitue une position, dite verrouillée, et l'extraction d'un appareil est obtenue par une opération de déverrouillage.

Il est ainsi possible de manière très rapide, soit simplement d'ajouter un appareil utile au fonctionnement, soit d'intervenir sur un appareil pour le réparer ou pour le remplacer par un autre ayant d'autres caractéristiques, ce qui justifie l'utilisation d'un système de rack même pour un unique appareil.

On trouve des appareils placés dans des racks dans de nombreux domaines d'activités tels que les laboratoires, sites industriels, salles de contrôle, etc., domaines dans lesquels les dispositifs de fixation à verrouillage sont d'un usage courant et donnent globalement satisfaction.

Mais dans d'autres cas, notamment ceux où les racks sont "embarqués", c'est à dire montés par exemple à bord d'avions, ou de chars ou d'hélicoptères, l'utilisation de ces dispositifs classiques de fixation à verrouillage pose de nombreux problèmes. Dans le cas par exemple d'un avion, les conditions de fonctionnement des matériels embarqués sont particulièrement difficiles. Les appareils peuvent être soumis notamment à des vibrations et/ou à des accélérations et décélérations importantes, qui exigent de renforcer les moyens qui servent à leur fixation.

Dans la demande de brevet français FR 2 787 282, la déposante a décrit un dispositif de fixation par verrouillage d'un appareil monté dans un rack qui permette de fixer un appareil de manière rapide et sure, de l'extraire facilement, et qui soit par ailleurs applicable aux appareils montés dans les avions et, plus généralement, aux appareils embarqués, pour lesquels les conditions de fixation sont soumises à des contraintes sévères.

Pour cela, le dispositif décrit dans la demande ci-dessus mentionnée comprend un premier et un second éléments de fixation solidaires respectivement de l'appareil et du rack, le premier élément étant déplacé par manoeuvre d'une poignée afin de coopérer avec l'autre élément pour fixer l'appareil dans le rack. II comprend par ailleurs un mécanisme de verrouillage de la poignée agissant à l'extérieur du rack sur ladite poignée et formé selon un exemple d'une lame ressort montée entre la face avant de l'appareil et un cadre bordant ladite face avant sur ses quatre côtés, la lame ressort étant positionnée de telle sorte à enserrer la poignée pour la bloquer quand celle-ci est amenée dans sa position de verrouillage.

Ce système, particulièrement efficace, présente cependant l'inconvénient de réduire la zone de vision utile en face avant du fait de la présence de pièces saillantes (lame ressort), ce qui est particulièrement gênant notamment dans le cas d'un appareil de type visu pour lequel on cherche toujours à obtenir une zone de vision utile maximale pour des dimensions minimales du rack, notamment dans le cas où cet appareil serait destiné à être embarqué.

La présente invention permet de remédier à cet inconvénient en proposant un système de fixation par verrouillage dans lequel le mécanisme de verrouillage agit sur le flan latéral de la poignée, permettant ainsi de ne pas avoir de pièces saillantes en face avant.

Plus précisément, l'invention propose un dispositif de fixation par verrouillage d'un appareil destiné à être monté dans un rack comprenant
- des premier et second éléments de fixation solidaires respectivement de l'appareil et du rack, le premier élément étant déplacé par manoeuvre d'une poignée afin de coopérer avec l'autre élément pour fixer l'appareil dans le rack,
- un mécanisme de verrouillage de ladite poignée,
le dispositif étant caractérisé en ce que la poignée présente un organe de préhension relié à un corps de poignée situé sur un côté de l'appareil et en ce que le mécanisme de verrouillage comprend un crochet coulissant servant de butée audit corps de poignée en position verrouillée.

Le dispositif de fixation selon l'invention permet en outre, grâce au crochet coulissant, un déverrouillage de la poignée en face avant, ne nécessitant pas ainsi d'introduire un espace supplémentaire sur les côtés de l'appareil pour procéder au déverrouillage, et permettant de ce fait une optimisation de la taille de la face avant de l'appareil par rapport à l'encombrement latéral du rack.

D'autres avantages et caractéristiques apparaîtront plus clairement à la lecture de la description qui suit, illustrée par les figures annexées qui représentent :
- La figure 1, un schéma d'un dispositif de fixation selon l'invention ;
- La figure 2, une vue du mécanisme de verrouillage selon un exemple de réalisation du dispositif de fixation selon l'invention ;
- Les figures 3A et 3B, les vues du mécanisme de verrouillage décrit sur la figure 2 dans deux positions, respectivement non verrouillée et verrouillée.
- Les figures 4A et 4B, des schémas montrant deux variantes de réalisation du mécanisme de verrouillage décrit sur la figure 2.

Sur ces figures, les éléments identiques sont indexés par les mêmes repères.

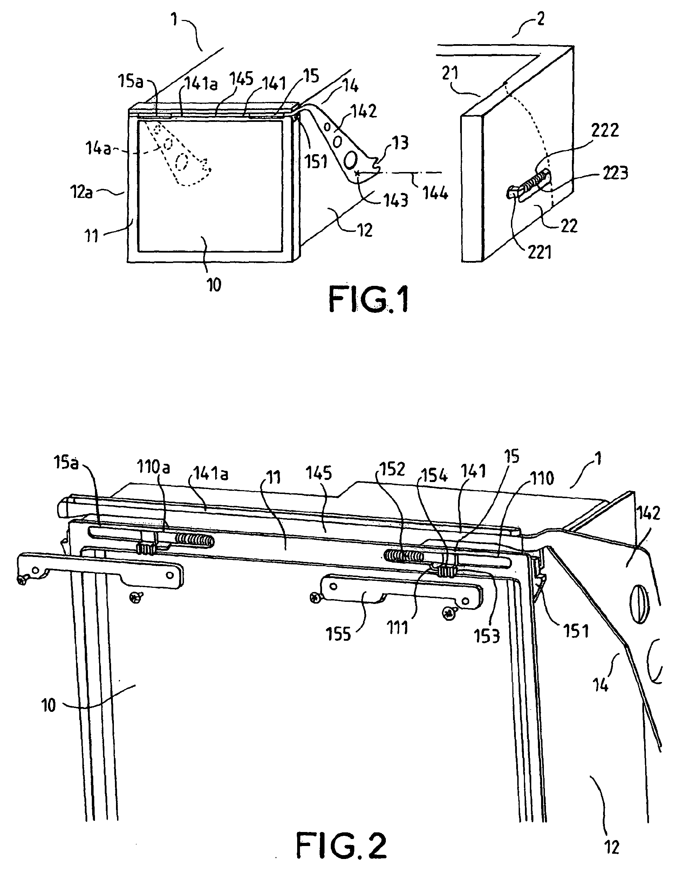

La figure 1 représente par un schéma simplifié un appareil 1, destiné à être fixé dans un rack ou châssis 2. Par souci de clarté l'appareil et le rack sont représentés de façon éclatée. L'appareil 1 est par exemple un appareil de visu avec une face avant 10 formée dans cet exemple d'un écran et généralement bordée sur ses quatre cotés d'un cadre (ou bandeau) rigide 11, permettant une manutention de l'objet sans agir sur le verre de l'écran. Par face avant, on entend la face visible par un utilisateur une fois que l'appareil est fixé dans le rack, par opposition à la face arrière qui porte le connecteur (non représentée). Les côtés 12 de l'appareil s'insèrent le long des parois latérales 21 du rack 2. Le rack est destiné à recevoir un ou plusieurs appareils, agencés les uns à côté des autres et/ou les uns au-dessus des autres. Dans le cas d'appareils embarqués, les dimensions extérieures en largeur comme en hauteur du rack sont généralement fixées par les contraintes d'encombrement. Le problème est alors de trouver un dispositif, de fixation sûr qui permette en outre de rendre maximale la zone utile de la face avant, c'est-à-dire la taille de l'écran visible par l'utilisateur dans le cas d'un appareil de visu.

Le dispositif de fixation selon l'invention répond à cette double contrainte. Il comprend pour cela d'une part un premier élément de fixation 13 solidaire de l'appareil 1 et un second élément de fixation 22 solidaire du rack 2, le premier élément étant déplacé par manoeuvre d'une poignée 14 afin de coopérer avec l'autre élément pour fixer l'appareil dans le rack, et d'autre part un mécanisme de verrouillage 15 de la poignée. Selon l'invention, la poignée présente un organe de préhension 141 relié à un corps de poignée 142 situé sur un côté de l'appareil 12. Le mécanisme de verrouillage 15 comprend un crochet coulissant 151 servant de butée audit corps de poignée 142 en position verrouillée. Le mécanisme de verrouillage 15 du dispositif de fixation selon l'invention permet, grâce à la mise en oeuvre du crochet qui vient en butée sur le corps de poignée qui constitue le flan latéral de la poignée, de rendre maximale la zone utile de la face avant, car aucune pièce saillante en face avant n'est nécessaire pour le fonctionnement du mécanisme de verrouillage. En outre, le déverrouillage peut se faire par actionnement du crochet coulissant en face avant, évitant ainsi un déverrouillage par actionnement du mécanisme de verrouillage sur les côtés de l'appareil, ce qui demanderait de prévoir de la place sur les côtés de l'appareil et réduirait donc la zone utile en face avant de l'appareil.

Dans l'exemple non limitatif de la figure 1, le corps de poignée 142 est solidaire du côté de l'appareil 12 par l'intermédiaire d'un pivot tournant 143 autour d'un axe 144. Sur la figure 1, l'axe 144 est représenté horizontal, la poignée étant manoeuvrée par l'utilisateur selon un mouvement de rotation du bas vers le haut pour fixer l'appareil de telle sorte que l'organe de préhension 141 de la poignée longe en position verrouillée le bord supérieur de la face avant, mais il est bien entendu que le même dispositif de fixation pourrait être transposé à 90° de telle sorte que l'organe de préhension longe un bord latéral de la face avant. Dans ce cas, la manoeuvre de la poignée pour fixer l'appareil se ferait de gauche à droite ou inversement. De même, le dispositif de fixation peut être agencé pour qu'en position verrouillée, l'organe de préhension de la poignée longe le bord inférieur de la face avant et dans ce cas, la manoeuvre de la poignée pour fixer l'appareil dans le rack est effectué du haut vers le bas.

Dans l'exemple de la figure 1, le premier élément de fixation 13 est formé par un crochet porté par une extrémité du corps de poignée 142. L'autre extrémité du corps de poignée, opposée par rapport au pivot 143, est reliée à l'organe de préhension 141. Le second élément de fixation 22, solidaire du rack 2, comprend dans cet exemple un pion saillant 221 dont la forme est complémentaire à celle du crochet 13 permettant de les assujettir l'un à l'autre lorsque l'appareil est enfoncé dans le rack pour être fixé. Dans cet exemple de réalisation, le pion saillant 221 peut se déplacer le long d'une coulisse 222 formée dans le rack longitudinalement (c'est-à-dire dans la direction des forces de maintien des connecteurs) ; il est associé à un ressort taré 223 de telle sorte que la manoeuvre de la poignée 13 entraîne la mise en tension du ressort, permettant d'assurer le maintien en contact des connecteurs avec une force suffisante pour contenir les mouvements relatifs dus aux vibrations entre l'appareil et le rack. Il s'agit ainsi de vaincre les forces de frottements entre les contacts males et femelles du connecteur lors de l'insertion ou de l'extraction de l'appareil.

Avantageusement, l'appareil 1 est fixé au rack 2 par deux côtés opposés 12, 12a, comme c'est le cas dans l'exemple de la figure 1. Il y a alors trois points de fixation, le connecteur et les côtés 12 et 12a qui bloquent les trois directions de déplacement x, y, z. Pour cela, le dispositif de fixation comprend des éléments agencés symétriquement de part et d'autre de l'appareil. Il comprend ainsi des premiers éléments de fixation sur deux côtés opposés de l'appareil, ces premiers éléments de fixation étant déplacés par la manoeuvre de deux poignées 14, 14a afin de coopérer avec des seconds éléments de fixation solidaires du rack, et deux mécanismes de verrouillage 15, 15a sensiblement identiques pour chacune des poignées. Dans l'exemple de la figure 1, les organes de préhension 141, 141 a des deux poignées se rejoignent pour former un barreau central 145 permettant la manoeuvre simultanée des deux poignées.

Nous décrivons maintenant plus en détails un exemple de réalisation du mécanisme de verrouillage du dispositif selon l'invention, représenté sur la figure 2. Sur cette figure, le rack n'est pas représenté.

Dans cet exemple de réalisation, le mécanisme de verrouillage comprend le crochet coulissant 151 destiné à servir de butée pour le corps de poignée 142 en position verrouillée ainsi qu'un ressort de compression 152 associé à une butée 153 permettant de maintenir le crochet en position de butée. Le crochet coulissant et le ressort de compression sont intégrés avantageusement dans un logement 110 du cadre de la face avant de l'appareil, permettant ainsi de s'affranchir de pièces saillantes en face avant et permettant en outre, de positionner la poignée en position verrouillée le long du cadre de telle sorte qu'elle ne réduise pas la zone utile en face avant ; il n'y a pas ainsi de réduction de l'angle de vue. Plus généralement, le logement du mécanisme de verrouillage peut être formé dans un rebord qui longe un côté de la face avant. Le mécanisme de verrouillage comprend en outre un bouton poussoir 154 solidaire du crochet et situé en face avant de l'appareil permettant à l'utilisateur d'escamoter le crochet coulissant pour déverrouiller la poignée. Dans cet exemple, le bouton poussoir peut se déplacer dans un logement 111 du cadre 11 qui s'étend parallèlement au logement 110 et dont un bord forme la butée 153 contre laquelle le bouton poussoir vient se bloquer, permettant d'arrêter la course du crochet 151 dans sa position de butée pour le corps de poignée. Une plaque de fermeture 155 est vissée afin de fermer le logement 110, assurant ainsi le maintien du crochet 151 et du ressort de compression 152 ainsi que le guidage du bouton poussoir 154.

Bien entendu, dans le cas où l'appareil serait fixé dans le rack par deux côtés opposés, il convient de veiller à ce que les mécanismes de verrouillages 15, 15a agissent bien simultanément si les deux poignées sont actionnées dans un même mouvement. La symétrie des mécanismes 15 et 15a permet avantageusement de garantir une translation strictement parallèle à l'axe des contacts du connecteur, évitant ainsi un éventuel arc-boutement de l'appareil sur le connecteur et/ou le rack, ainsi qu'une détérioration des contacts en cas de point de contact unique.

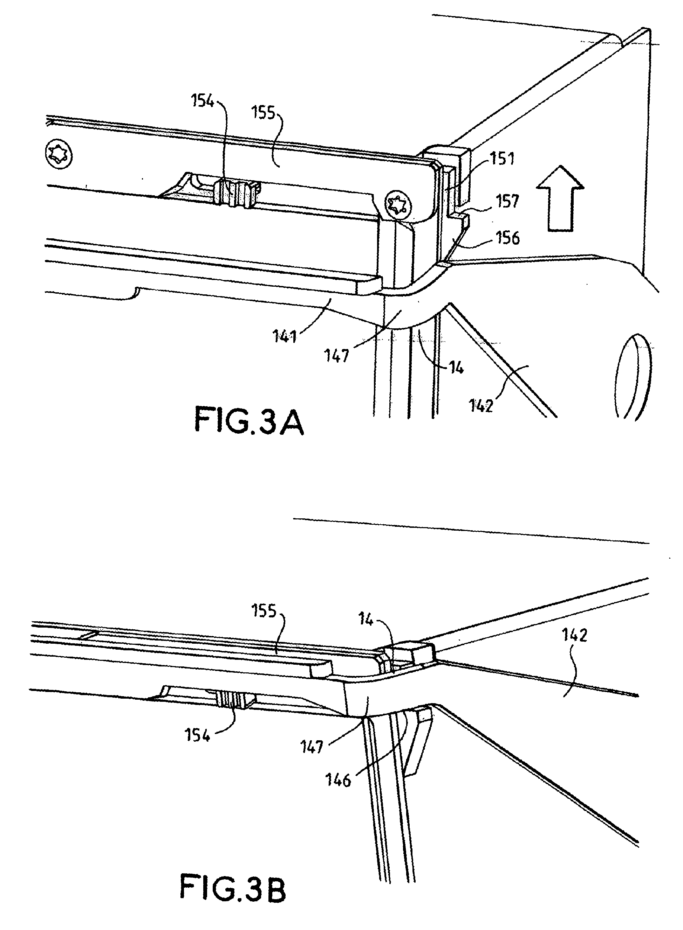

Les figures 3A et 3B permettent de mieux comprendre le mécanisme de verrouillage et de déverrouillage de la poignée dans le dispositif de fixation selon l'invention. Le mécanisme représenté est celui de la figure 2, dans lequel la plaque de fermeture 155 est en place, cachant de ce fait le ressort de compression et la partie interne du crochet coulissant 151. La figure 3A représente la phase de verrouillage. Dans cet exemple, le verrouillage est effectué par une manoeuvre du bas vers le haut de la poignée, comme cela est symbolisé par la flèche. L'utilisateur fait pivoter la poignée 14 du bas vers le haut. Le corps de poignée 142 vient en contact avec la partie externe du crochet 151. Avantageusement, une pente 156 est pratiquée sur la partie externe du crochet 151 permettant à la poignée d'escamoter le crochet et de libérer ainsi son passage. Après le passage de la poignée, le ressort de compression (non visible sur la figure 3A) repositionne le crochet en position sortie (la course du crochet étant limitée par la mise en butée du bouton poussoir 154) faisant ainsi obstacle au retour de la poignée, qui se trouve en position verrouillée.

La figure 3B représente ainsi la poignée dans sa position verrouillée. Avantageusement, le crochet 151 présente un plan d'appui 157 qui coopère avec un plan d'appui 146 du corps de poignée pour servir de butée. Selon une variante préférentielle, le plan d'appui 146 du corps de poignée s'étend longitudinalement (c'est-à-dire de l'avant vers l'arrière de l'appareil), permettant ainsi d'encaisser les défauts de positionnement du mécanisme de verrouillage par rapport au plan qui contient la face avant de l'appareil. Dans l'exemple des figures 3A et 3B, le corps de poignée 142 présente ainsi un décrochement 147 sur son extrémité reliée à l'organe de préhension 141, permettant d'assurer un plan d'appui 146 dont la dimension longitudinale est supérieure à celle du plan d'appui 157 du crochet.

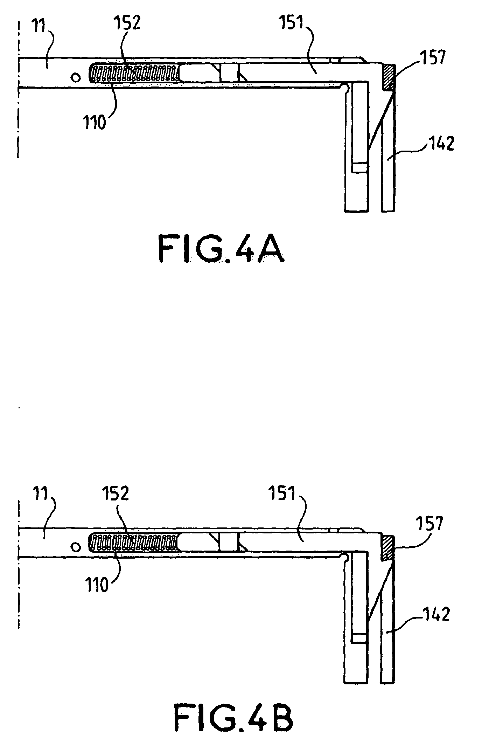

Les plans d'appui peuvent être plats, c'est-à-dire dans un plan parallèle à l'axe de coulisse du crochet, assurant une butée franche du corps de poignée sur le crochet. Selon une variante, les plans d'appui peuvent être en biseau, ce qui assure une sécurité supplémentaire en milieu vibratoire sévère. Ces deux modes de réalisation sont schématisés sur les figures 4A et 4B qui représentent le mécanisme de verrouillage (sans la plaque de fermeture), vu de face. La figure 4A montre le crochet 151 avec un plan d'appui 157 plat coopérant avec le plan d'appui du corps de poignée 142. Sur la figure 4B, les plans d'appui sont représentés en biseau.

Pour déverrouiller la poignée lorsqu'elle est en position verrouillée telle que représentée sur la figure 3B, l'utilisateur soulève légèrement la poignée pour dégager le crochet 151 et agit sur le bouton poussoir 154 de telle sorte à s'opposer à la force du ressort de compression pour escamoter le crochet coulissant vers l'intérieur de son logement dans le cadre de la face avant, libérant ainsi la poignée qui peut être abaissée.

## Revendications

1. Dispositif de fixation par verrouillage d'un appareil (1) comprenant une face avant (10) et au moins deux cotés latéraux (12) destiné à être monté dans un rack (2) comprenant des parois latérales (21) le long desquelles s'insèrent les cotés latéraux (12) de l'appareil (1), ledit dispositif comprenant :
- des premier (13) et second (22) éléments de fixation solidaires respectivement des deux cotés latéraux (12) de l'appareil et des parois latérales (21) du rack, le premier élément étant déplacé par manoeuvre d'une poignée (14, 14a) afin de coopérer avec l'autre élément pour fixer l'appareil dans le rack,
- un mécanisme de verrouillage (15, 15a) de ladite poignée,
- la poignée (14) présentant un organe de préhension (141, 141a) relié à un corps de poignée (142) situé sur un côté latéral (12) de l'appareil,
**caractérisé en ce que** :
- le mécanisme de verrouillage comprend un crochet coulissant (151) situé sur un des côtés latéraux (12) près d'un bord de la face avant (10) et un ressort de compression (152), agencés de sorte que, dans la phase de verrouillage,
- la poignée étant manoeuvrée par l'utilisateur selon un mouvement de rotation pour fixer l'appareil, le corps de poignée (142) longe le côté latéral comportant le crochet (151), escamotant ledit crochet (151), libérant ainsi le passage de ladite poignée (14),
- après le passage de la poignée, le ressort de compression (152) repositionne le crochet (151) servant ainsi de butée audit corps de poignée en position verrouillée.

2. Dispositif de fixation selon la revendication 1, **caractérisé en ce que** le crochet (151) présente un plan d'appui (157) coopérant avec un plan d'appui (146) du corps de poignée pour servir de butée.

3. Dispositif de fixation selon la revendication 2, **caractérisé en ce que** lesdits plans d'appui sont dans un plan parallèle à l'axe de coulisse du crochet.

4. Dispositif de fixation selon la revendication 2, **caractérisé en ce que** lesdits plans d'appui sont dans un plan en biseau par rapport à l'axe de coulisse du crochet.

5. Dispositif de fixation selon l'une des revendications 2 à 4, **caractérisé en ce que** le plan d'appui (146) du corps de poignée s'étend longitudinalement, sa dimension longitudinale étant supérieure à celle du plan d'appui (157) du crochet.

6. Dispositif de fixation selon l'une des revendications précédentes, **caractérisé en ce que** le mécanisme de verrouillage (15) comprend un ressort de compression (152) associé à une butée (153) permettant de maintenir le crochet en position de butée pour le corps de poignée en position verrouillée de la poignée.

7. Dispositif de fixation selon la revendication 6, **caractérisé en ce que** l'appareil présentant une face avant avec un rebord agencé sur au moins l'un de ses côtés, le crochet coulissant et le ressort de compression sont intégrés dans un logement (110) formé dans ledit rebord.

8. Dispositif de fixation selon la revendication 7, **caractérisé en ce que** l'appareil présentant une face avant bordée par un cadre (11), ledit rebord forme un côté du cadre.

9. Dispositif de fixation selon l'une des revendications 6 à 8, **caractérisé en ce que** le mécanisme de verrouillage comprend en outre un bouton poussoir (154) solidaire du crochet et situé en face avant de l'appareil permettant à un utilisateur d'escamoter le crochet coulissant pour déverrouiller la poignée.

10. Dispositif de fixation selon la revendication 9, **caractérisé en ce que** le bouton poussoir (154) peut de déplacer dans un logement (111) dont un bord forme ladite butée (153) pour le crochet coulissant.

11. Dispositif selon l'une des revendications 9 ou 10, **caractérisé en ce que** le mécanisme de verrouillage comprend une plaque de fermeture (155) dudit logement.

12. Dispositif de fixation selon l'une des revendications 6 à 11, **caractérisé en ce qu'**une pente (156) est pratiquée sur le crochet coulissant (151) permettant, lors du verrouillage de la poignée, d'escamoter ledit crochet.

13. Dispositif de fixation selon l'une des revendications précédentes, **caractérisé en ce que** le corps de poignée est solidaire du côté de l'appareil par l'intermédiaire d'un pivot tournant (143).

14. Dispositif de fixation selon la revendication 13, **caractérisé en ce que** le premier élément de fixation (13) est porté par une extrémité du corps de poignée, opposée par rapport audit pivot de l'extrémité à laquelle est relié l'organe de préhension (141).

15. Dispositif de fixation selon la revendication 14, **caractérisé en ce que** le premier élément de fixation (13) et le second élément de fixation (22), solidaire du rack, ont des formes complémentaires permettant de les assujettir l'un à l'autre lorsque l'appareil est enfoncé dans le rack pour être fixé.

16. Dispositif de fixation selon la revendication 15, **caractérisé en ce que** le premier élément (13) est formé d'un crochet et le second élément (22) est formé d'un pion saillant (221) pouvant se déplacer le long d'une coulisse (222) formée dans le rack et associé à un ressort taré (223) de telle sorte que la manoeuvre de la poignée entraîne la mise en tension dudit ressort taré.

17. Dispositif de fixation selon l'une des revendications précédentes, **caractérisé en ce qu'**il comprend des premiers éléments de fixation sur deux côtés opposés de l'appareil, ces premiers éléments de fixation étant déplacés par la manoeuvre de deux poignées (14, 14a) afin de coopérer avec des seconds éléments de fixation solidaires du rack, et **en ce qu'**il comprend deux mécanismes de verrouillage (15, 15a) sensiblement identiques pour chacune des dites poignées.

18. Dispositif de fixation selon la revendication 17, **caractérisé en ce que** les organes de préhension (141, 141a) des deux poignées se rejoignent pour former un barreau central (145) permettant la manoeuvre simultanée des deux poignées.

19. Rack équipé d'au moins un appareil fixé au moyen d'un dispositif de fixation selon l'une des revendications précédentes, **caractérisé en ce qu'**il présente, sur chacune de ses parois latérales (21) située en vis-à-vis d'un côté de l'appareil (12) le long duquel se situe un corps de poignée (142), une sous épaisseur permettant de loger ledit corps de poignée.

## Claims

1. Device for lock-fixing an apparatus (1) comprising a front face (10), and at least two lateral sides (12) designed to be mounted in a rack (2) comprising side walls (21) along which the lateral sides (12) of the apparatus (1) are inserted, said device comprising:
- first (13) and second (22) fixing elements respectively secured to the two lateral sides (12) of the apparatus and to the side walls (21) of the rack, the first element being moved by operating a handle (14, 14a) in order to interact with the other element to fix the apparatus in the rack,
- a mechanism (15, 15a) for locking said handle,
- the handle (14) having a gripping member (141, 141a) connected to a handle body (142) situated on a lateral side (12) of the apparatus,
**characterized in that**:
- the locking mechanism comprises a sliding hook (151) situated on one of the lateral sides (12) close to an edge of the front face (10) and a compression spring (152), arranged so that, in the locking phase,
- the handle being operated by the user in a rotary movement to fix the apparatus, the handle body (142) moves along the lateral side comprising the hook (151), retracting said hook (151), thus freeing said handle (14) to pass,
- after the passage of the handle, the compression spring (152) repositions the hook (151) thus serving as an abutment to said handle body in the locked position.

2. Fixing device according to Claim 1, **characterized in that** the hook (151) has a bearing plane (157) interacting with a bearing plane (146) of the handle body to serve as an abutment.

3. Fixing device according to Claim 2, **characterized in that** said bearing planes are in a plane parallel to the sliding axis of the hook.

4. Fixing device according to Claim 2, **characterized in that** said bearing planes are in a plane beveled relative to the sliding axis of the hook.

5. Fixing device according to one of Claims 2 to 4, **characterized in that** the bearing plane (146) of the handle body extends longitudinally, its longitudinal dimension being greater than that of the bearing plane (157) of the hook.

6. Fixing device according to one of the preceding Claims, **characterized in that** the locking mechanism (15) comprises a compression spring (152) associated with an abutment (153) used to hold the hook in the abutment position for the handle body in the locked position of the handle.

7. Fixing device according to Claim 6, **characterized in that** the apparatus having a front face with a rim arranged on at least one of its sides, the sliding hook and the compression spring are integrated into a housing (110) formed in said edge.

8. Fixing device according to Claim 7, **characterized in that** the apparatus having a front face rimmed by a frame (11), said rim forms one side of the frame.

9. Fixing device according to one of Claims 6 to 8, **characterized in that** the locking mechanism also comprises a pushbutton (154) secured to the hook and situated on the front face of the apparatus allowing a user to retract the sliding hook to unlock the handle.

10. Fixing device according to Claim 9, **characterized in that** the pushbutton (154) may be moved in a housing (111) one edge of which forms said abutment (153) for the sliding hook.

11. Device according to either of Claims 9 and 10, **characterized in that** the locking mechanism comprises a plate (155) for closing said housing.

12. Fixing device according to one of Claims 6 to 11, **characterized in that** a slope (156) is made on the sliding hook (151) allowing said hook to be retracted during locking of the handle.

13. Fixing device according to one of the preceding claims, **characterized in that** the handle body is secured to the side of the apparatus via a rotating pivot (143).

14. Fixing device according to Claim 13, **characterized in that** the first fixing element (13) is supported by one end of the handle body, opposite relative to said pivot of the end to which the gripping member (141) is connected.

15. Fixing device according to Claim 14, **characterized in that** the first fixing element (13) and the second fixing element (22), secured to the rack, have complementary shapes making it possible to fasten them to one another when the apparatus is pushed into the rack to be fixed.

16. Fixing device according to Claim 15, **characterized in that** the first element (13) is formed of a hook and the second element (22) is formed of a projecting pin (221) that can be moved along a slide (222) formed in the rack and is associated with a spring (223) calibrated so that the operation of the handle causes said calibrated spring to be placed in tension.

17. Fixing device according to one of the preceding claims, **characterized in that** it comprises first fixing elements on two opposite sides of the apparatus, these first fixing elements being moved by the operation of two handles (14, 14a) in order to interact with second fixing elements secured to the rack, and **in that** it comprises two locking mechanisms (15, 15a) substantially identical for each of said handles.

18. Fixing device according to Claim 17, **characterized in that** the gripping members (141, 141a) of the two handles join together to form a central bar (145) allowing the two handles to be operated simultaneously.

19. Rack equipped with at least one apparatus fixed by means of a fixing device according to one of the preceding claims, **characterized in that** it has, on each of its side walls (21) situated facing one side of the apparatus (12) along which is situated a handle body (142), an area of reduced thickness allowing said handle body to be housed.

## Patentansprüche

1. Vorrichtung zum Befestigen durch Verriegeln eines Geräts (1), das eine vordere Fläche (10) und wenigstens zwei Seiten (12) aufweist und dazu bestimmt ist, in einem Einschubschrank (2) angebracht zu werden, der Seitenwände (21) aufweist, längs derer die Seiten (12) des Geräts (1) eingeschoben werden, wobei die Vorrichtung enthält:
- ein erstes Element (13) und ein zweites Element (22) zum Befestigen der zwei Seiten (12) des Geräts und der Seitenwände (21) des Einschubschranks aneinander, wobei das erste Element durch Betätigen eines Griffs (14, 14a) verlagert wird, damit es mit dem anderen Element zusammenwirkt, um das Gerät im Einschubschrank zu befestigen,
- einen Verriegelungsmechanismus (15, 15a) für den Griff,
- wobei der Griff (14) ein Greiforgan (141, 141a) aufweist, das mit einem Griffkörper (142) verbunden ist, der sich an einer Seite (12) des Geräts befindet,
**dadurch gekennzeichnet, dass**:
- der Verriegelungsmechanismus einen Gleithaken (151), der sich an einer der Seiten (12) in der Nähe einer Kante der vorderen Fläche (10) befindet, und eine Kompressionsfeder (152) enthält, die so beschaffen sind, dass in der Verriegelungsphase
- dann, wenn der Griff durch den Anwender mit einer Drehbewegung zum Befestigen des Geräts betätigt wird, der Griffkörper (142) sich entlang der den Haken (151) aufweisenden Seite bewegt, wodurch der Haken (151) eingezogen wird und der Durchgang des Griffs (14) freigegeben wird,
- nach der Vorbeibewegung des Griffs die Kompressionsfeder (152) den Haken (151) wieder positioniert, so dass er als Anschlag an dem Griffkörper in der verriegelten Position dient.

2. Befestigungsvorrichtung nach Anspruch 1, **dadurch gekennzeichnet, dass** der Haken (151) eine Abstützebene (157) aufweist, die mit einer Abstützebene (146) des Griffkörpers zusammenwirkt, um als Anschlag zu dienen.

3. Befestigungsvorrichtung nach Anspruch 2, **dadurch gekennzeichnet, dass** die Abstützebenen in einer Ebene liegen, die zur Gleitachse des Hakens parallel ist.

4. Befestigungsvorrichtung nach Anspruch 2, **dadurch gekennzeichnet, dass** die Abstützebenen in einer Ebene liegen, die in Bezug auf die Gleitachse des Hakens geneigt ist.

5. Befestigungsvorrichtung nach einem der Ansprüche 2 bis 4, **dadurch gekennzeichnet, dass** sich die Abstützebene (146) des Griffkörpers longitudinal erstreckt, wobei ihre longitudinale Abmessung größer als jene der Abstützebene (157) des Hakens ist.

6. Befestigungsvorrichtung nach einem der vorhergehenden Ansprüche, **dadurch gekennzeichnet, dass** der Verriegelungsmechanismus (15) eine Kompressionsfeder (152) enthält, der ein Anschlag (153) zugeordnet ist, der ermöglicht, den Haken in der Anschlagposition für den Griffkörper in der verriegelten Position des Griffs zu halten.

7. Befestigungsvorrichtung nach Anspruch 6, **dadurch gekennzeichnet, dass** das Gerät eine vordere Fläche aufweist, wobei an wenigstens einer seiner Seiten eine Kante angeordnet ist, wobei der Gleithaken und die Kompressionsfeder in einen Aufnahmesitz (110) integriert sind, der in der Kante ausgebildet ist.

8. Befestigungsvorrichtung nach Anspruch 7, **dadurch gekennzeichnet, dass** dann, wenn das Gerät eine durch einen Rahmen (11) eingefasste vordere Fläche aufweist, die Kante eine Seite des Rahmens bildet.

9. Befestigungsvorrichtung nach einem der Ansprüche 6 bis 8, **dadurch gekennzeichnet, dass** der Verriegelungsmechanismus außerdem einen Druckknopf (154) aufweist, der mit dem Haken fest verbunden ist und sich an der vorderen Fläche des Geräts befindet, was es einem Anwender ermöglicht, den Gleithaken einzuziehen, um den Griff zu entriegeln.

10. Befestigungsvorrichtung nach Anspruch 9, **dadurch gekennzeichnet, dass** sich der Druckknopf (154) in einem Aufnahmesitz (111) verlagern kann, wovon ein Rand den Anschlag (153) für den Gleithaken bildet.

11. Vorrichtung nach einem der Ansprüche 9 oder 10, **dadurch gekennzeichnet, dass** der Verriegelungsmechanismus eine Verschlussplatte (155) für den Aufnahmesitz enthält.

12. Befestigungsvorrichtung nach einem der Ansprüche 6 bis 11, **dadurch gekennzeichnet, dass** an dem Gleithaken (151) eine Schräge (156) ausgebildet ist, die es bei der Verriegelung des Griffs ermöglicht, den Haken einzuziehen.

13. Befestigungsvorrichtung nach einem der vorhergehenden Ansprüche, **dadurch gekennzeichnet, dass** der Griffkörper mit der Seite des Geräts über einen Drehzapfen (143) fest verbunden ist.

14. Befestigungsvorrichtung nach Anspruch 13, **dadurch gekennzeichnet, dass** das erste Befestigungselement (13) durch ein Ende des Griffkörpers getragen wird, das sich in Bezug auf den Zapfen gegenüber dem Ende befindet, mit dem das Grifforgan (141) verbunden ist.

15. Befestigungsvorrichtung nach Anspruch 14, **dadurch gekennzeichnet, dass** das erste Befestigungselement (13) und das zweite Befestigungselement (22), das mit dem Einschubschrank fest verbunden ist, komplementäre Formen haben, was es ermöglicht, sie aneinander zu befestigen, wenn das Gerät in den Einschubschrank eingesetzt wird, um befestigt zu werden.

16. Befestigungsvorrichtung nach Anspruch 15, **dadurch gekennzeichnet, dass** das erste Element (13) aus einem Haken gebildet ist und das zweite Element (22) aus einem vorstehenden Höcker (221), der sich längs einer in dem Einschubschrank ausgebildeten Gleitschiene (222) verlagern kann und dem eine vorgespannte Feder (223) zugeordnet ist, gebildet ist, derart, dass die Betätigung des Griffs das Spannen der vorgespannten Feder zur Folge hat.

17. Befestigungsvorrichtung nach einem der vorhergehenden Ansprüche, **dadurch gekennzeichnet, dass** sie an zwei gegenüberliegenden Seiten des Geräts erste Befestigungselemente aufweist, wobei diese ersten Befestigungselemente durch die Betätigung von zwei Griffen (14, 14a) verlagert werden, damit sie mit zweiten Befestigungselementen, die mit dem Einschubschrank fest verbunden sind, zusammenwirken, und dadurch, dass sie zwei im Wesentlichen identische Verriegelungsmechanismen (15, 15a) für jeden der Griffe enthält.

18. Befestigungsvorrichtung nach Anspruch 17, **dadurch gekennzeichnet, dass** die Grifforgane (141, 141a) der zwei Griffe sich vereinigen, um einen Mittelstab (145) zu bilden, der die gleichzeitige Betätigung der zwei Griffe ermöglicht.

19. Einschubschrank, der mit wenigstens einem Gerät ausgerüstet ist, das mittels einer Befestigungsvorrichtung nach einem der vorhergehenden Ansprüche befestigt ist, **dadurch gekennzeichnet, dass** er an jeder seiner Seitenwände (21), die sich jeweils gegenüber einer Seite des Geräts (12) befinden, längs derer sich ein Griffkörper (142) befindet, eine verringerte Dicke aufweist, was es ermöglicht, den Griffkörper unterzubringen.
